(19)
**Europäisches Patentamt**
**European Patent Office**
**Office européen des brevets**

(11) **EP 3 584 588 A1**

(12) **EUROPÄISCHE PATENTANMELDUNG**

(43) Veröffentlichungstag:
25.12.2019  Patentblatt 2019/52

(21) Anmeldenummer: 19178510.4

(22) Anmeldetag: 05.06.2019

(51) Int Cl.:
*G01R 15/04* (2006.01)     *G01R 35/02* (2006.01)
*G01R 1/20* (2006.01)      *G01R 15/08* (2006.01)
*G01R 19/00* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: 15.06.2018  DE 102018114432

(71) Anmelder: **Bundesrepublik Deutschland, vertr. durch das Bundesministerium f. Wirtschaft und Technologie, 38116 Braunschweig (DE)**

(72) Erfinder: **PASSON, Stephan 38118 Braunschweig (DE)**

(74) Vertreter: **Gramm, Lins & Partner Patent- und Rechtsanwälte PartGmbB Theodor-Heuss-Straße 1 38122 Braunschweig (DE)**

(54) **SPANNUNGSTEILER**

(57)  Die Erfindung betrifft einen Spannungsteiler mit (a) einem Eingangsanschluss (12), (b) einem Ausgangsanschluss (14), (c) einem Bezugswiderstand (16) und (d) einer Widerstandskaskade (18). Erfindungsgemäß ist vorgesehen, dass (e) die Widerstandskaskade (18) (i) eine Mehrzahl an Kaskaden-Widerständen (20.i) aufweist, wobei zumindest ein Kaskaden-Widerstand (20.9) veränderbar ist, und (ii) zumindest eine Kontaktierungsvorrichtung (22) aufweist, mittels der die Kaskaden-Widerstände ($R_{Hi}$) in eine Reihenschaltung und in eine Parallelschaltung bringbar sind, und die (iii) mit dem Bezugswiderstand (16) zwischen dem Eingangsanschluss (12) und dem Ausgangsanschluss (14) in Reihe geschaltet ist, und dass (f) der Spannungsteiler (10) einen Hilfsteiler (24) hat, der (i) einen ersten Hilfsteiler-Eingang (26), der mit dem Eingangsanschluss (12) schaltbar verbindbar ist, (ii) einen zweiten Hilfsteiler-Eingang (28), der mit dem Eingangsanschluss (12) schaltbar verbindbar ist, (iii) einen ersten Hilfsteiler-Widerstand (25.1), (iv) einen veränderbaren zweiten Hilfsteiler-Widerstand (25.2), (v) einen Hilfsteiler-Ausgang (30), der zwischen dem ersten Hilfsteiler-Widerstand (25.1) und dem zweiten Hilfsteiler-Widerstand (25.2) liegt und (vi) einen Hilfsteiler-Schalter (S2) aufweist, mittels dem der Eingangsanschluss (12) alternierend mit dem ersten Hilfsleiter-eingang (26) und dem zweiten Hilfsleiter-Eingang (28) verbindbar ist, (g) der Bezugswiderstand (16) und die Widerstandskaskade (18) in Reihe geschaltet sind, und dass (h) der Spannungsteiler (10) einen Spannungsmesser-Anschluss (32) hat, der zwischen der Widerstandskaskade (18) und dem Bezugswiderstand (16) liegt.

Fig. 1

**Beschreibung**

Die Erfindung betrifft einen Spannungsteiler mit (a) einem Eingangsanschluss, (b) einem Ausgangsanschluss, (c) einem Bezugswiderstand und (d) einer Widerstandskaskade. Gemäß einem zweiten Aspekt betrifft die Erfindung ein Verfahren zum Kalibrieren eines Spannungsteilers oder einer Spannungsteilvorrichtung.

Spannungsteiler werden verwendet, um hohe Spannungen möglichst genau messen zu können. Die SI-Einheit der Spannung wird durch ein Primärnormal dargestellt, das zumindest einen Josephson-Kontakt hat. Die von Josephson-Kontakten abgegebene Spannung ist sehr klein, sodass ein Vergleich mit dieser Spannung voraussetzt, dass die zu messende Mess-Spannung um mehrere Größenordnungen geteilt wird. Der Teilungsfaktor, der auch Maßstabsfaktor genannt wird, muss durch Kalibrierung ermittelt werden. Bei bekannten Spannungsteilern ist diese Kalibrierung sehr aufwendig.

Aus der US 2 803 799 A ist ein gattungsgemäßer Spannungsteiler bekannt, bei dem ein veränderbarer Widerstand verwendet wird, der zu einem Teil der Widerstandskaskade parallel geschaltet ist. Umfasst dieser Spannungsteiler eine Vielzahl an Kaskaden-Widerständen, so ist die Kalibrierung dieses Spannungsteilers sehr aufwändig.

Aus der US 3 886 448 A ist ein Hochspannungsteiler bekannt, der ohne Widerstandskaskade auskommt.

Aus der US 3 377 555 A ist ein weiterer Hochspannungsteiler bekannt, dessen Widerstandskaskade keinen veränderbaren Kaskadenwiderstand aufweist.

Der Erfindung liegt die Aufgabe sugrunde, das Kalibrieren von Spannungsteilem zu vereinfachen.

Die Erfindung löst das Problem durch einen gattungsgemäßen Spannungsteiler, bei dem die Widerstandskaskade (i) eine Mehrzahl an Kaskaden-Widerständen aufweist, wobei zumindest ein Kaskaden-Widerstand veränderbar ist, und (ii) zumindest eine Kontaktierungsvorrichtung aufweist, mittels der die Kaskadenwiderstände in eine Reihenschaltung und in eine Parallelschaltung bringbar sind, wobei die Widerstandskaskade (iii) mit dem Bezugswiderstand zwischen den Eingangsanschluss und im Ausgangsanschluss in Reihe geschaltet ist. Der Spannungsteiler hat einen Hilfsteiler, der (i) einen ersten Hilfsteiler-Eingang, der mit dem Eingangsanschluss schaltbar verbindbar ist, (ii) einen zweiten Hilfsteiler-Eingang, der mit dem Eingangsanschluss schaltbar verbindbar ist, (iii) einen ersten Hilfsteiler-Widerstand, (iv) einen veränderbaren zweiten Hilfsteiler-Widerstand, (v) einen Hilfsteiler-Ausgang, der zwischen dem ersten Hilfsteiler-Widerstand und dem zweiten Hilfsteiler-Widerstand liegt und einen Hilfsteiler-Schalter aufweist, mittels dem wahlweise der erste Hilfsteiler-Eingang oder der zweite Hilfsteiler-Eingang mit dem Eingangsanschluss verbindbar ist. Der Betriebswiderstand und die Kaskaden-Widerstände sind in Reihe geschaltet und der Spannungsteiler hat einen Spannungsmesser-Anschluss, der zwischen der Widerstandskaskade und dem Bezugswiderstand liegt.

Die Erfindung löst das Problem zudem durch ein Verfahren zum Kalibrieren eines solchen Spannungsteilers mit den Schritten: (i) Schalten der Kaskaden-Widerstände in eine Parallelschaltung, (ii) Verbinden des ersten Hilfsteiler-Eingangs mit dem Eingangsanschluss mittels des Hilfsteiler-Schalters, (iii) Anlegen einer Prüfung-Spannung an den Eingangsanschluss, (iv) Angleichen des zweiten Hilfsteiler-Widerstands an den ersten Hilfsteiler-Widerstand, danach (v) Verändern des zumindest einen veränderbaren Kaskaden-Widerstands, bis eine Differenz-Spannung zwischen dem Hilfsteiler-Ausgang und dem Spannungsmesser-Anschluss unterhalb einer vorgegebenen Schwellenspannung, insbesondere unterhalb von 10 Mikrovolt, liegt, und (vi) Schalten der Kaskaden-Widerstände in eine Reihenschaltung.

Vorteilhaft an der Erfindung ist, dass die Kalibrierung des Spannungsteilers, insbesondere bei einer hohen Anzahl an Kaskaden-Widerständen, die sich in ihren elektrischen Widerständen kaum voneinander unterscheiden, einfach möglich ist. Insbesondere ist es entbehrlich, jeden einzelnen Kaskaden-Widerstand zu vermessen und daraus den Reihen-Kaskadenwiderstand zu bestimmen, den die Widerstandskaskade hat, wenn die Kaskaden-Widerstände in Reihe geschaltet sind.

Vorzugsweise weist die Kontaktierungsvorrichtung eine Mehrzahl an Metallstäben auf, mittels denen die Kaskaden-Widerstände in eine Parallelschaltung und alternativ dazu in eine Reihenschaltung gebracht werden können. Die Metallstäbe sind beispielsweise vergoldete Metallstäbe, insbesondere vergoldete Kupferstäbe. Auf diese Weise wird eine Oxidation und damit ein undefinierter Übergangswiderstand vermieden.

Günstig ist es, wenn die Kaskaden-Widerstände elektrische Widerstandswerte haben, die sich untereinander um höchstens 100 ppm unterscheiden. Je geringer die Schwankung der elektrischen Widerstandswerte untereinander ist, desto genauer lässt sich der Spannungsteiler abgleichen, wie unten gezeigt wird. Insbesondere sind die Kaskaden-Widerstände baugleich, das heißt, dass sie aus den gleichen Materialien auf gleiche Art und Weise hergestellt wurden.

Beispielsweise handelt es sich bei den Kaskaden-Widerständen um Dünnfilmwiderstände, die durch dünne Metallschichten auf einem Nichtleiter gebildet sind. Die Metallschichten haben eine bekannte Dicke sowie bekannte räumliche Abmaße. Beispielsweise sind die Kaskaden-Widerstände durch Herausätzen aus einer Metallbeschichtung auf einem nicht leitenden Substrat entstanden.

Vorzugsweise beträgt eine Widerstandsanzahl an Kaskaden-Widerständen zumindest 50, vorzugsweise zumindest 100. Die Widerstandsanzahl ist vorzugsweise kleiner als 10 000, vorzugsweise kleiner als 5000.

Günstig ist es, wenn der Spannungsteiler eine Temperiervorrichtung zum Halten der Temperatur des Spannungsteilers innerhalb eines vorgegebenen Temperaturintervalls aufweist. Beispielsweise hat das Temperaturintervall eine Intervallbreite von 0,2 Kelvin. Derartige Temperiervorrichtungen sind aus dem Stand der Technik bekannt und werden daher nicht weiter beschrieben.

Erfindungsgemäß ist zudem eine Spannungsteilvorrichtung mit einem erfindungsgemäßen Spannungsteiler und einem Spannungsmesser, der mit dem Spannungsmesser-Anschluss und dem Hilfsteiler-Ausgang verbunden ist. Auf diese Weise kann ein erfindungsgemäßes Verfahren direkt durchgeführt werden.

Im Rahmen eines erfindungsgemäßen Verfahrens ist die Prüf-Spannung vorzugsweise kleiner als 100 Volt und beträgt vorzugsweise höchstens 30 Volt. Als besonders geeignet haben sich 20 Volt herausgestellt. Die Prüfspannung wird an den Eingangsanschluss angelegt. Hierunter wird verstanden, dass die Spannung zwischen dem Eingangs- und dem Ausgangsanschluss anliegt. Der Ausgangsanschluss wird in der Regel geerdet. Selbstverständlich ist es auch möglich, dass der Eingangsanschluss geerdet und der Ausgangsanschluss ungeerdet ist oder das keiner der beiden Anschlüsse geerdet ist.

Vorzugsweise umfasst der Schritt des Angleichens des zweiten Hilfsteiler-Widerstands an den ersten Hilfsteiler-Widerstand die folgenden Schritte: alternierendes Verbinden des Eingangsanschlusses mit dem ersten Hilfsteiler-Eingang und dem zweiten Hilfsteiler-Eingang und Verändern des veränderbaren zweiten Hilfsteiler-Widerstands, bis eine Differenz-Spannung zwischen dem Spannungsmesser-Anschluss und dem Hilfsteiler-Ausgang bis auf eine vorgegebene Toleranzspannung, die beispielsweise höchstens 15 Mikrovolt beträgt, unabhängig davon ist, ob der Eingangs-Anschluss mit dem ersten Hilfsteiler-Eingang oder dem zweiten Hilfsteiler-Eingang verbunden ist. Auf diese Weise ist der zweite elektrische Hilfsteiler-Widerstand in guter Näherung gleich dem ersten elektrischen Hilfsteiler-Widerstand.

Das alternierende Verbinden des Eingangs-Anschlusses mit dem ersten Hilfsteiler-Eingang und dem zweiten Hilfsteiler-Eingang bewirkt jeweils eine Umkehrung der Stromrichtung des Stroms, der durch den ersten Hilfsteiler-Widerstand und den zweiten Hilfsteiler-Widerstand fließt. Das alternierende Verbinden erfolgt mit dem Hilfsteiler-Schalter. In einer ersten Schalterstellung des Hilfsteiler-Schalters verläuft der Stromfluss vom ersten Hilfsteiler-Widerstand zum zweiten Hilfsteiler-Widerstand. In der zweiten Schalterstellung des Hilfsteiler-Schalters verläuft die Stromrichtung entsprechend vom zweiten Hilfsteiler-Widerstand zum ersten Hilfsteiler-Widerstand. Wenn das Umschalten keine Änderung der Spannung ehr bewirkt, sind die elektrischen Widerstandswerte des ersten Hilfsteiler-Widerstands und des zweiten Hilfsteiler-Widerstands gleich. Der Hilfsteiler hat dann ein Teilungsverhältnis von 2 zu 1.

Der Spannungsteiler funktioniert grundsätzlich für alle Spannungsbereiche, insbesondere für Spannungen von zumindest 20 kV und theoretisch auch für 5 MV und mehr. Insbesondere ist vorzugsweise der Spannungsteiler zum Anlegen einer Mess-Spannung von zumindest 100 Kilovolt, insbesondere zumindest 300 Kilovolt, ausgebildet.

Im Folgenden wird die Erfindung anhand der beigefügten Figuren näher erläutert. Dabei zeigt

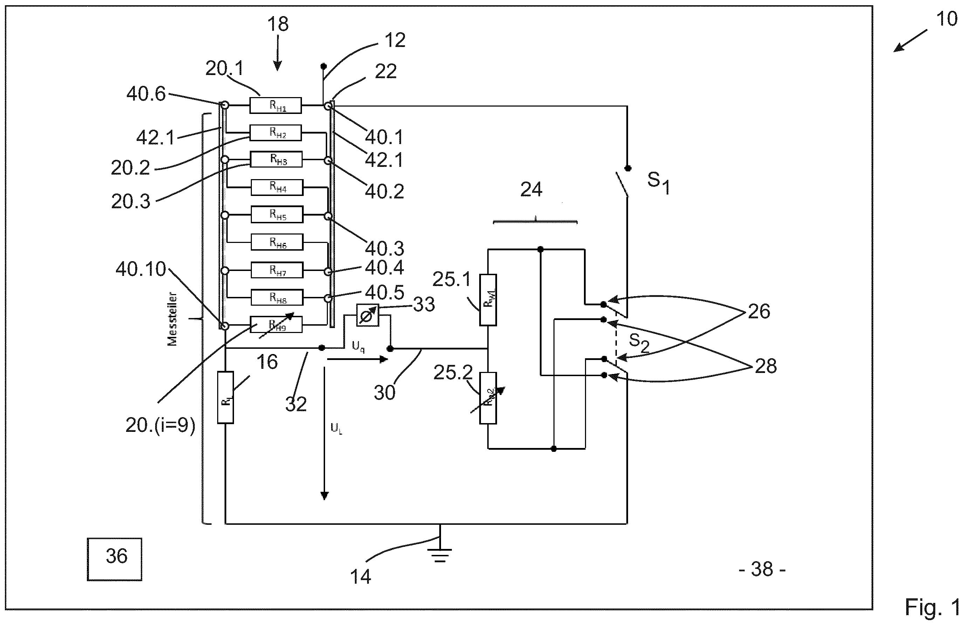

Figur 1     ein Schaltbild des erfindungsgemäßen Spannungsteilers und der erfindungsgemäßen Spannungsteilvorrichtung zum Durchführen eines erfindungsgemäßen Verfahrens.

Figur 1 zeigt ein Schaltbild eines erfindungsgemäßen Spannungsteilers 10, der einen Eingangsanschluss 12, einen Ausgangsanschluss 14, einen Bezugswiderstand 16 und eine Widerstandskaskade 18 aufweist. Die Widerstandskaskade 18 besitzt eine Mehrzahl an Kaskaden-Widerständen 20.i (i = 1, 2, ..., n).

Der Spannungsteiler 10 umfasst zudem eine Kontaktierungsvorrichtung 22, mittels der die Kaskaden-Widerstände 20.i entweder in eine Reihenschaltung oder eine Parallelschaltung bringbar sind.

Der Spannungsteiler 10 besitzt zudem einen Hilfsteiler 24, der einen ersten Hilfsteiler-Eingang 26, einen zweiten Hilfsteiler-Eingang 28, sowie einen Hilfsteiler-Ausgang 30 aufweist. Der Hilfsteiler 24 besitzt zudem einen Hilfsteiler-Schalter S2, mittels dem der Eingangs-Anschluss 12 alternierend mit dem ersten Hilfsteiler-Eingang 26 und dem zweiten Hilfsteiler-Eingang 28 verbunden werden kann.

Mittels eines Zentralschalters S1 kann der Hilfsteiler 24 vom Eingangs-Anschluss 12 getrennt werden. Der Zentralschalter S1 wird geöffnet, wenn der Spannungsteiler 10 kalibriert ist und eine Mess-Spannung $U_{mess}$, die mit hoher Genauigkeit gemessen werden soll, an den Eingangsanschluss 12 angelegt wird. Der Ausgangsanschluss 14 ist in der Regel geerdet.

Figur 1 zeigt, dass der Bezugswiderstand 16 und die Widerstandskaskade 18 in Reihe geschaltet sind. Zwischen dem Bezugswiderstand 16 und der Widerstandskaskade 18 ist ein Spannungsmesser-Anschluss 32 vorhanden. Der Spannungsmesser-Anschluss kann beispielsweise eine Buchse sein oder alternativ lediglich durch einen freiliegenden Leiter gebildet sein.

Figur 1 zeigt, dass die Kontaktierungsvorrichtung 22 eine Mehrzahl an Metallstäben 34.j (j = 1, 2, ..., n-1) aufweist, um, wie oben beschrieben, die Kaskaden-Widerstände 20.i sowohl in eine Parallelschaltung als auch eine Reihenschaltung bringen zu können.

Schematisch ist eine Temperiervorrichtung 36 eingezeichnet, die beispielsweise eine schematisch eingezeichnete Grundstruktur, auf dem der Spannungsteiler 10 aufgebaut ist, auf einer vorgegebenen Temperatur $T_{Soll}$ hält.

Der elektrische Widerstand $R_L$ des Bezugswiderstands 16 ist mit hoher Genauigkeit bekannt. Beispielsweise ist der elektrische Widerstand $R_L$ mit einer Messunsicherheit von höchstens 100 ppm bekannt.

EP 3 584 588 A1

Zunächst werden gemäß in einem Schritt (i) die Kaskaden-Widerstände 20.i in eine Parallelschaltung gebracht. In der Parallelschaltung der Kaskaden-Widerstände 20.i gilt für die den Parallel-Kaskadenwiderstand $R_H$ der Widerstandskaskade 18 $\frac{1}{R_H} = \sum_{i=1}^{n} \frac{1}{R_{Hi}}$. Danach wird der erste Hilfsteiler-Eingang 26 mittels des Hilfsteiler-Schalters S2 mit dem Eingangsanschluss 12 verbunden. In einem weiteren Schritt (ii) wird eine Prüf-Spannung $U_{prüf}$ an den Eingangsanschluss 12 angelegt.

In einem nachfolgenden Schritt (iii) werden die beiden elektrischen Hilfsteiler-Widerstände $R_{W2}$ und $R_{W1}$ der Hilfsteiler-Widerstände 25.1 und 25.2 dadurch aneinander angeglichen, dass alternierend der erste Hilfsteiler-Eingang und der zweite Hilfsteiler-Eingang 26 bzw. 28 mit dem Eingangsanschluss 12 verbunden werden.

Ist der erste Hilfsteiler-Eingang 26 mit dem Eingangsanschluss 12 verbunden, so fließt der Strom gemäß der technischen Stromrichtung abhängig vom Vorzeichen der Prüfspannung $U_{prüf}$ beispielsweise vom ersten Hilfsteiler-Widerstand 25.1 zum zweiten Hilfsteiler-Widerstand 25.2 und von dort zum Ausgangsanschluss. Wird der Hilfsteiler-Schalter S2 umgeschaltet, so fließt der Strom vom Eingangsanschluss 12 zunächst zum zweiten Hilfsteiler-Widerstand 25.2, dann zum ersten Hilfsteiler-Widerstand 25.1 und danach zum Ausgangsanschluss 14. Der zweite Hilfsteiler-Widerstand 25 wird so verändert, dass eine Differenzspannung $U_q$ zwischen dem Hilfsteiler-Ausgang 30 und dem Spannungsmesser-Anschluss 32, die mit einem Spannungsmesser 33 gemessen wird, unabhängig von der Stellung des Hilfsteiler-Schalters S2 ist. In diesem Fall sind die elektrischen Hilfsteiler-Widerstände $R_{W1}$ und $R_{W2}$ gleich groß.

Für den Gesamtwiderstand $R_{ges}$ der Schaltung aus Bezugswiderstand $R_L$ und Widerstandskaskade $R_H$ gilt bei geöffnetem Zentralschalter $S_1$:

$$R_{ges} = R_L + R_H = R_L + \frac{1}{\sum_{i=1}^{n} \frac{1}{R_{Hi}}}$$

Durch das Angleichen des zweiten elektrischen Hilfsteiler-Widerstands $R_{W2}$ an den ersten elektrischen Hilfsteiler-Widerstand $R_{W1}$ gilt $R_{W1} = R_{W2}$.

Nun wird in einem Schritt (v) der elektrischer Widerstand $R_{H(i=n)}$ des veränderbaren Kaskaden-Widerstands (20.n), im vorliegenden Fall also des Kaskaden-Widerstands 20.9 so verändert, dass $U_q = 0V$ gilt.

Dann gilt $\frac{R_{W2}}{R_{W1}} = \frac{R_H}{R_L}$ und damit

$$\frac{R_{W2}}{R_{W1}} = 1 = \frac{\left(\sum_{i=1}^{n} \frac{1}{R_{Hi}}\right)^{-1}}{R_L} = \frac{1}{R_L\left(\sum_{i=1}^{n} \frac{1}{R_{Hi}}\right)} \Leftrightarrow \frac{1}{R_L} = \sum_{i=1}^{n} \frac{1}{R_{Hi}}$$

Da die $R_{Hi}$ sich kaum unterscheiden, kann jeder Widerstand $R_{Hi}$ geschrieben werden als kleine Abweichung von einem Mittelwert $\overline{R_H}$:

$$R_{Hi} = \overline{R_H}\left(1 + \frac{\Delta R_{Hi}}{\overline{R_H}}\right)$$

Daraus folgt

$$\frac{1}{R_L} = \sum_{i=1}^{n} \frac{1}{R_{Hi}} = \sum_{i=1}^{n} \frac{1}{\overline{R_H}\left(1 + \frac{\Delta R_{Hi}}{\overline{R_H}}\right)} = \frac{1}{\overline{R_H}} \sum_{i=1}^{n} \frac{1}{\left(1 + \frac{\Delta R_{Hi}}{\overline{R_H}}\right)} =$$

$$= \frac{1}{\overline{R_H}} \sum_{i=1}^{n} \left(1 - \frac{\Delta R_{Hi}}{\overline{R_H}} + O\left(\left[\frac{\Delta R_{Hi}}{\overline{R_H}}\right]^2\right)\right)$$

$$\frac{1}{R_L} = n\frac{1}{\overline{R_H}} + \underbrace{\frac{1}{\overline{R_H}} \sum_{i=1}^{n} \frac{\Delta R_{Hi}}{\overline{R_H}}}_{geht\ für\ große\ n\ gegen\ null} + \underbrace{\sum_{i=1}^{n} O\left(\left[\frac{\Delta R_{Hi}}{\overline{R_H}}\right]^2\right))}_{zu\ vernachlässigen}$$

Wird für die Abweichung eine Normalverteilung angenommen, so strebt der Term $\frac{1}{\overline{R_H}}\sum_{i=1}^{n}\frac{\Delta R_{Hi}}{\overline{R_H}}$ für große n gegen null. Dann folgt

$$R_H \approx nR_L$$

In einem nachfolgenden Schritt (vi) werden die Kaskaden-Widerstände 20.1 in eine Reihenschaltung gebracht. Dazu werden Metallstifte 40.1, 40.2, ...40.10 entfernt, die bislang eine elektrische Verbindung mit zwei Verbindungsleitern 42.1, 42.2 herstellten, was die Kaskaden-Widerstände 20.1 parallel schaltete.
Der Gesamtwiderstand nach dem Bringen der Widerstandskaskade in eine Reihenschaltung ist $R_{ges} = R_L + R_H = (1 + n)\,R_L$.
Ist die Widerstandskaskade in Parallelschaltung, so gilt:

$$R_{ges} = R_L + R_H = R_L + \frac{1}{n\frac{1}{\overline{R_H}} + \underbrace{\frac{1}{\overline{R_H}}\sum_{i=1}^{n}\frac{\Delta R_{Hi}}{\overline{R_H}}}_{geht\ für\ große\ n\ gegen\ null}} = \quad R_L + \frac{1}{n\frac{1}{\overline{R_H}}} = R_L + \frac{\overline{R_H}}{n}$$

Durch das Umwandeln der Widerstandskaskade aus der Parallelschaltung in die Reihenschaltung um den Faktor

$$F = \frac{(1+n)R_L}{R_L + \frac{\overline{R_H}}{n}} = \frac{1+n}{1 + \frac{\overline{R_H}}{nR_L}} = (1+n)\left(1 - \frac{\overline{R_H}}{nR_L}\right) = 1 - \frac{\overline{R_H}}{nR_L} + n - \frac{\overline{R_H}}{R_L}$$

Wenn, was bevorzugt ist, $\overline{R_H} \approx R_L$ gilt,

$$F \approx n - \frac{\overline{R_H}}{nR_L}.$$

Für große n folgt $F \approx n$.
Nachfolgend wird der Zentralschalter S1 geöffnet und der Spannungsteiler ist betriebsbereit.
Die obige Berechnung lässt sich inhaltlich auch über den folgenden Weg herleiten. So ergibt sich für 2 Widerstände

$$\frac{1}{R_{LV} \cdot \varepsilon} = \frac{1}{R + \Delta R_1} + \frac{1}{R + \Delta R_2}$$

$$\frac{1}{R_{LV} \cdot \varepsilon} = \frac{(R + \Delta R_2) + (R + \Delta R_1)}{(R + \Delta R_1) \cdot (R + \Delta R_2)}$$

$$\frac{1}{R_{LV} \cdot \varepsilon} = \frac{2R + \Delta R_1 + \Delta R_2}{R^2 + R \cdot \Delta R_2 + R \cdot \Delta R_1 + \Delta R_1 \cdot \Delta R_2}$$

$$\frac{1}{R_{LV} \cdot \varepsilon} = \frac{2R + \Delta R_1 + \Delta R_2}{R^2 + R \cdot (\Delta R_1 \cdot \Delta R_2) + \Delta R_1 \cdot \Delta R_2}$$

$$\xRightarrow{\Delta R_i^2 \ll R} \frac{1}{R_{LV} \cdot \varepsilon} = \frac{2R + \Delta R_1 + \Delta R_2}{R^2 + R \cdot (\Delta R_1 + \Delta R_2)} = \frac{2R}{R^2} \cdot \frac{1 + \frac{1}{2R} \cdot (\Delta R_1 + \Delta R_2)}{1 + \frac{1}{R} \cdot (\Delta R_1 + \Delta R_2)}$$

$$\frac{1}{R_{LV} \cdot \varepsilon} = \frac{2}{R} \cdot \frac{1 + \frac{1}{2R} \cdot (\Delta R_1 + \Delta R_2)}{1 + \frac{1}{R} \cdot (\Delta R_1 + \Delta R_2)}$$

Darin ist ε die Abweichung vom wahren Wert.

Für 3 Widerstände ergibt sich:

$$\frac{1}{R_{LV} \cdot \varepsilon} = \frac{1}{R + \Delta R_1} + \frac{1}{R + \Delta R_2} + \frac{1}{R + \Delta R_3}$$

$$\frac{1}{R_{LV} \cdot \varepsilon} = \frac{(R + \Delta R_2) \cdot (R + \Delta R_3) + (R + \Delta R_1) \cdot (R + \Delta R_3) + (R + \Delta R_1) \cdot (R + \Delta R_2)}{(R + \Delta R_1) \cdot (R + \Delta R_2) \cdot (R + \Delta R_3)}$$

$$\frac{1}{R_{LV} \cdot \varepsilon} = \frac{\begin{array}{c} R^2 + R \cdot (\Delta R_2 + \Delta R_3) + \Delta R_2 \cdot \Delta R_3 \\ + R^2 + R \cdot (\Delta R_1 + \Delta R_3) + \Delta R_1 \cdot \Delta R_3 \\ + R^2 + R \cdot (\Delta R_1 + \Delta R_2) + \Delta R_1 \cdot \Delta R_2 \end{array}}{\begin{array}{c} R^3 + R^2 \cdot \Delta R_3 + R^2 \cdot \Delta R_2 + R \cdot \Delta R_2 \cdot \Delta R_3 + R^2 \cdot \Delta R_1 \\ + R \cdot \Delta R_1 \cdot \Delta R_3 + R \cdot \Delta R_1 \cdot \Delta R_2 + \Delta R_1 \cdot \Delta R_2 \cdot \Delta R_3 \end{array}}$$

$$\frac{1}{R_{LV} \cdot \varepsilon}$$

$$= \frac{3R^2 + 2R \cdot (\Delta R_1 + \Delta R_2 + \Delta R_3) + \Delta R_1 \cdot \Delta R_2 + \Delta R_1 \cdot \Delta R_3 + \Delta R_2 \cdot \Delta R_3}{R^3 + R^2 \cdot (\Delta R_1 + \Delta R_2 + \Delta R_3) + R \cdot (\Delta R_1 \cdot \Delta R_2 + \Delta R_1 \cdot \Delta R_3 + \Delta R_2 \cdot \Delta R_3) + \Delta R_1 \cdot \Delta R_2 \cdot \Delta R_3}$$

$$\xRightarrow{\Delta R_i^2 \ll R} \frac{1}{R_{LV} \cdot \varepsilon} = \frac{3R^2 + 2R \cdot (\Delta R_1 + \Delta R_2 + \Delta R_3)}{R^3 + R^2 \cdot (\Delta R_1 + \Delta R_2 + \Delta R_3)} = \frac{3R^2}{R^3} \cdot \frac{1 + \frac{2}{3R} \cdot (\Delta R_1 + \Delta R_2 + \Delta R_3)}{1 + \frac{1}{R} \cdot (\Delta R_1 + \Delta R_2 + \Delta R_3)}$$

$$\frac{1}{R_{LV} \cdot \varepsilon} = \frac{3}{R} \cdot \frac{1 + \frac{2}{3R} \cdot (\Delta R_1 + \Delta R_2 + \Delta R_3)}{1 + \frac{1}{R} \cdot (\Delta R_1 + \Delta R_2 + \Delta R_3)}$$

Für *n* Widerstände folgt daraus:

$$\frac{1}{R_{LV} \cdot \varepsilon} = \frac{n}{R} \cdot \frac{1 + \frac{n-1}{n \cdot R} \cdot \sum_{i=1}^{n} \Delta R_i}{1 + \frac{1}{R} \cdot \sum_{i=1}^{n} \Delta R_i} = \frac{1}{R} \cdot \frac{n + (n-1) \cdot \sum_{i=1}^{n} \frac{\Delta R_i}{R}}{1 + \sum_{i=1}^{n} \frac{\Delta R_i}{R}} \Leftrightarrow R_{LV}$$

$$= R \cdot \frac{1 + \sum_{i=1}^{n} \frac{\Delta R_i}{R}}{n + (n-1) \cdot \sum_{i=1}^{n} \frac{\Delta R_i}{R}}$$

$$\xRightarrow{R = n \cdot R_{LV}} R_{LV} \cdot \varepsilon = n \cdot R_{LV} \cdot \frac{1 + \sum_{i=1}^{n} \frac{\Delta R_i}{R}}{n + (n-1) \cdot \sum_{i=1}^{n} \frac{\Delta R_i}{R}} = R_{LV} \cdot \frac{1 + \sum_{i=1}^{n} \frac{\Delta R_i}{R}}{1 + \left(1 - \frac{1}{n}\right) \cdot \sum_{i=1}^{n} \frac{\Delta R_i}{R}}$$

$$\Rightarrow \varepsilon = \frac{1 + \sum_{i=1}^{n} \frac{\Delta R_i}{R}}{1 + \left(1 - \frac{1}{n}\right) \cdot \sum_{i=1}^{n} \frac{\Delta R_i}{R}} = \frac{1 + n \cdot \frac{\overline{\Delta R}}{R}}{1 + \left(1 - \frac{1}{n}\right) \cdot n \cdot \frac{\overline{\Delta R}}{R}} = \frac{1 + n \cdot \frac{\overline{\Delta R}}{R}}{1 + (n-1) \cdot \frac{\overline{\Delta R}}{R}}$$

$$\xRightarrow{\varepsilon = 1 + \delta R_{Soll}} 1 + \delta R_{Soll} = \frac{1 + n \cdot \frac{\overline{\Delta R}}{R}}{1 + (n-1) \cdot \frac{\overline{\Delta R}}{R}} = \frac{1 + (n-1) \cdot \frac{\overline{\Delta R}}{R} + \frac{\overline{\Delta R}}{R}}{1 + (n-1) \cdot \frac{\overline{\Delta R}}{R}} = 1 + \frac{\frac{\overline{\Delta R}}{R}}{1 + (n-1) \cdot \frac{\overline{\Delta R}}{R}}$$

$$\Rightarrow \delta R_{Soll} = \frac{\frac{\overline{\Delta R}}{R}}{1 + (n-1) \cdot \frac{\overline{\Delta R}}{R}}$$

mit

$$\frac{\overline{\Delta R}}{R} = \frac{1}{n} \cdot \sum_{i=1}^{n} \frac{\Delta R_i}{R} \Leftrightarrow \sum_{i=1}^{n} \frac{\Delta R_i}{R} = n \cdot \frac{\overline{\Delta R}}{R}.$$

Es ist zu erkennen, dass unter der Voraussetzung $\Delta R_i^2 \ll R$ Anteile höherer Potenzen von $R_i$ verschwinden. Die Formel lässt sich soweit vereinfachen, dass für die Abweichung vom Sollwert nur die Anzahl der Widerstände und der Mittelwert der Abweichungen benötigt werden.

**Bezugszeichenliste**

10    Spannungsteiler
12    Eingangsanschluss
14    Ausgangsanschluss
16    Bezugswiderstand
18    Widerstandskaskade

20    Kaskaden-Widerstand
22    Kontaktierungsvorrichtung
24    Hilfsteiler
25    Hilfsteiler-Widerstand
26    erster Hilfsteiler-Eingang

28    zweiter Hilfsteiler-Eingang

30    Hilfsteiler-Ausgang
32    Spannungsmesser-Anschluss
33    Differenzspannungsmesser
34    Metallstab
36    Temperiervorrichtung
38    Substrat

40    Metallstab

$\varepsilon$    Abweichung vom wahren Wert
n    Zahl der Kaskaden-Widerstände
$R_H$    Parallel-Kaskadenwiderstände
S2    Hilfsteiler-Schalter
S1    Zentralschalter

$T_{soll}$    Temperatur
$U_{mess}$    Mess-Spannung
$U_{prüf}$    Prüf-Spannung
$U_q$    Differenz-Spannung


**Patentansprüche**

1.   Spannungsteiler mit

(a) einem Eingangsanschluss (12),
(b) einem Ausgangsanschluss (14),
(c) einem Bezugswiderstand (16) und
(d) einer Widerstandskaskade (18),
**dadurch gekennzeichnet, dass**
(e) die Widerstandskaskade (18)

(i) eine Mehrzahl an Kaskaden-Widerständen (20.i) aufweist, wobei zumindest ein Kaskaden-Widerstand (20.9) veränderbar ist, und
(ii) zumindest eine Kontaktierungsvorrichtung (22) aufweist, mittels der die Kaskaden-Widerstände ($R_{Hi}$) in eine Reihenschaltung und in eine Parallelschaltung bringbar sind, und die
(iii) mit dem Bezugswiderstand (16) zwischen dem Eingangsanschluss (12) und dem Ausgangsanschluss (14) in Reihe geschaltet ist, und dass

(f) der Spannungsteiler (10) einen Hilfsteiler (24) hat, der

(i) einen ersten Hilfsteiler-Eingang (26), der mit dem Eingangsanschluss (12) schaltbar verbindbar ist,
(ii) einen zweiten Hilfsteiler-Eingang (28), der mit dem Eingangsanschluss (12) schaltbar verbindbar ist,
(iii) einen ersten Hilfsteiler-Widerstand (25.1),
(iv) einen veränderbaren zweiten Hilfsteiler-Widerstand (25.2),
(v) einen Hilfsteiler-Ausgang (30), der zwischen dem ersten Hilfsteiler-Widerstand (25.1) und dem zweiten Hilfsteiler-Widerstand (25.2) liegt und
(vi) einen Hilfsteiler-Schalter (S2) aufweist, mittels dem der Eingangsanschluss (12) alternierend mit dem ersten Hilfsleiter-eingang (26) und dem zweiten Hilfsleiter-Eingang (28) verbindbar ist,

(g) der Bezugswiderstand (16) und die Widerstandskaskade (18) in Reihe geschaltet sind, und dass
(h) der Spannungsteiler (10) einen Spannungsmesser-Anschluss (32) hat, der zwischen der Widerstandskaskade (18) und dem Bezugswiderstand (16) liegt.

2.   Spannungsteiler nach Anspruch 1, **dadurch gekennzeichnet, dass** die Kontaktierungsvorrichtung (22) eine Mehrzahl an Metallstäben (34) umfasst.

3. Spannungsteiler nach einem der vorstehenden Ansprüche, **dadurch gekennzeichnet, dass** die Kaskaden-Widerstände (20) elektrische Widerstandswerte ($R_{Hi}$) haben, die sich untereinander um höchstens 100 ppm unterscheiden.

4. Spannungsteiler nach einem der vorstehenden Ansprüche, **dadurch gekennzeichnet, dass** eine Widerstandsanzahl (n) an Kaskaden-Widerständen (20) zumindest 50 beträgt und/oder höchstens 1 000 000 beträgt.

5. Spannungsteiler nach einem der vorstehenden Ansprüche, **gekennzeichnet durch** eine Temperiervorrichtung (36) zum Halten der Temperatur ($T_{soll}$) des Spannungsteilers (10) innerhalb eines vorgegebenen Temperaturintervalls.

6. Spannungsteilvorrichtung mit

(a) einem Spannungsteiler (10) nach einem der vorstehenden Ansprüche und
(b) einem Spannungsmesser, der mit dem Spannungsmesser-Anschluss (32) und dem Hilfsteiler-Ausgang(30) verbunden ist.

7. Verfahren zum Kalibrieren einer Spannungsteilvorrichtung nach Anspruch 6, **gekennzeichnet durch** die Schritte:

(i) Schalten der Kaskaden-Widerstände (20.i) in eine Parallelschaltung,
(ii) Verbinden des ersten Hilfsteiler-Eingangs (26) mit dem Eingangsanschluss (12),
(iii) Anlegen einer Prüf-Spannung ($U_{prüf}$) an den Eingangsanschluss (12),
(iv) Angleichen des zweiten elektrischen Hilfsteiler-Widerstands (25.2) an den ersten Hilfsteiler-Widerstand (25.1), danach
(v) Verändern des zumindest einen veränderbaren Kaskaden-Widerstands (20.9), bis eine Differenz-Spannung ($U_q$) zwischen

dem Hilfsteiler-Ausgang (30) und
dem Spannungsmesser-Anschluss (32)

unterhalb einer vorgegebenen Schwellenspannung, insbesondere unterhalb von 10 Mikrovolt, liegt, und
(vi) Schalten der Kaskaden-Widerstände (20.i) in eine Reihenschaltung.

8. Verfahren nach Anspruch 7, **dadurch gekennzeichnet, dass** der Schritt (iv) des Angleichens des zweiten Hilfsteiler-Widerstands (25.2) an den ersten Hilfsteiler-Widerstand (25.1) die folgenden Schritte umfasst:

- alternierendes Verbinden des Eingangsanschlusses (12) mit dem ersten Hilfsteiler-Eingang (26) und dem zweiten Hilfsteiler-Eingang (28) und
- Verändern des veränderbaren zweiten Hilfsteiler-Widerstands (25.2), bis eine Differenz-Spannung ($U_q$) zwischen dem Spannungsmesser-Anschluss (32) und dem Hilfsteiler-Ausgang (30) bis auf eine vorgegebene Toleranz unabhängig davon ist, ob der Eingangsanschluss (12) mit dem ersten Hilfsteiler-Eingang (26) oder dem zweiten Hilfsteiler-Eingang (28) verbunden ist (sodass der zweite Hilfsteiler-Widerstand (25.2) in guter Näherung dem ersten Hilfsteiler-Widerstand (25.1) entspricht).

9. Verfahren nach Anspruch 7 oder 8, **gekennzeichnet durch** die Schritte

- Anlegen einer zu messenden Mess-Spannung ($U_{mess}$) an den Eingang,
- Messen einer Teil-Spannung, die über dem Bezugswiderstand (16) abfällt, und
- Bestimmen der Mess-Spannung ($U_{mess}$) aus der Teil-Spannung.

10. Verfahren nach einem der Ansprüche 7 bis 9, **dadurch gekennzeichnet, dass** die Prüf-Spannung ($U_{prüf}$) höchstens 100 Volt beträgt und dass die Mess-Spannung ($U_{mess}$) zumindest 100 kV beträgt.

Fig. 1

Europäisches
Patentamt

European
Patent Office

Office européen
des brevets

**EUROPÄISCHER RECHERCHENBERICHT**

Nummer der Anmeldung

EP 19 17 8510

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | DRAGOUNOVA N: "Precision High-Voltage DC Dividers and Their Calibration", IEEE TRANSACTIONS ON INSTRUMENTATION AND MEASUREMENT, IEEE SERVICE CENTER, PISCATAWAY, NJ, US, Bd. 54, Nr. 5, 1. Oktober 2005 (2005-10-01), Seiten 1911-1915, XP011140128, ISSN: 0018-9456, DOI: 10.1109/TIM.2005.853222 * Seite 1913, linke Spalte - Seite 1914, linke Spalte; Abbildung 1 * ----- | 1-10 | INV. G01R15/04 G01R35/02 ADD. G01R1/20 G01R15/08 G01R19/00 |
| A | ECCLESTON L ET AL: "Calibrator brings record accuracy even to production and repair", ELECTRONICS INTERNATIONAL,, Bd. 55, Nr. 18, 8. September 1982 (1982-09-08), Seiten 121-127, XP001405808, * "Calibrating the calibrator"; Seite 124 * ----- | 1-10 | |
| A | CN 105 137 378 A (CHINA ELECTRIC POWER RES INST; STATE GRID CORP CHINA) 9. Dezember 2015 (2015-12-09) * Zusammenfassung; Abbildungen 2,3 * ----- | 1-10 | RECHERCHIERTE SACHGEBIETE (IPC) G01R |

-/--

Der vorliegende Recherchenbericht wurde für alle Patentansprüche erstellt

| Recherchenort | Abschlußdatum der Recherche | Prüfer |
|---|---|---|
| München | 8. November 2019 | Hof, Klaus-Dieter |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
.............................................................
& : Mitglied der gleichen Patentfamilie, übereinstimmendes
Dokument

EPO FORM 1503 03.82 (P04C03)

Europäisches
Patentamt

European
Patent Office

Office européen
des brevets

## EUROPÄISCHER RECHERCHENBERICHT

Nummer der Anmeldung

EP 19 17 8510

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | MICHAL LISOWSKI ET AL: "Resistance Scaling From 10 ${\rm k}\Omega$ Up to 100 ${\rm T}\Omega$ With New Designs of Hamon Transfer Devices", IEEE TRANSACTIONS ON INSTRUMENTATION AND MEASUREMENT, IEEE SERVICE CENTER, PISCATAWAY, NJ, US, Bd. 62, Nr. 6, 1. Juni 2013 (2013-06-01), Seiten 1749-1754, XP011508194, ISSN: 0018-9456, DOI: 10.1109/TIM.2013.2250132 * Seite 1749, linke Spalte - Seite 1750, rechte Spalte; Abbildungen 1,2 * ----- | 1-10 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| München | 8. November 2019 | Hof, Klaus-Dieter |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument
...................................................................
& : Mitglied der gleichen Patentfamilie, übereinstimmendes
   Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 17 8510

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-11-2019

| Im Recherchenbericht angeführtes Patentdokument | Datum der Veröffentlichung | Mitglied(er) der Patentfamilie | Datum der Veröffentlichung |
|---|---|---|---|
| CN 105137378 A | 09-12-2015 | KEINE | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

**In der Beschreibung aufgeführte Patentdokumente**

- US 2803799 A
- US 3886448 A
- US 3377555 A